(19) Europäisches Patentamt
European Patent Office
Office européen des brevets

(11) **EP 3 602 777 B1**

(12) **EUROPÄISCHE PATENTSCHRIFT**

(45) Veröffentlichungstag und Bekanntmachung des Hinweises auf die Patenterteilung:
**01.09.2021 Patentblatt 2021/35**

(21) Anmeldenummer: **18711298.2**

(22) Anmeldetag: **13.03.2018**

(51) Int Cl.:
*H03F 1/02* *(2006.01)*    *H03K 17/06* *(2006.01)*
*H03K 17/687* *(2006.01)*    *H03F 3/21* *(2006.01)*
*H03F 3/217* *(2006.01)*

(86) Internationale Anmeldenummer:
**PCT/EP2018/056165**

(87) Internationale Veröffentlichungsnummer:
**WO 2018/197096 (01.11.2018 Gazette 2018/44)**

(54) **VORRICHTUNG ZUR ANSTEUERUNG EINES SELBSTLEITENDEN N-KANAL ENDSTUFENFELDEFFEKTTRANSISTORS**

DEVICE FOR CONTROLLING A SELF-CONDUCTING N-CHANNEL OUTPUT STAGE FIELD EFFECT TRANSISTOR

DISPOSITIF POUR LA COMMANDE D'UN TRANSISTOR À EFFET DE CHAMP D'ÉTAGE FINAL À CANAL N AUTOCONDUCTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.04.2017 DE 102017108828**

(43) Veröffentlichungstag der Anmeldung:
**05.02.2020 Patentblatt 2020/06**

(73) Patentinhaber: **Ferdinand-Braun-Institut gGmbH, Leibniz-Institut für Höchstfrequenztechnik 12489 Berlin (DE)**

(72) Erfinder: **HOFFMANN, Thomas 13437 Berlin (DE)**

(74) Vertreter: **Gulde & Partner Patent- und Rechtsanwaltskanzlei mbB Wallstraße 58/59 10179 Berlin (DE)**

(56) Entgegenhaltungen:
EP-A1- 2 858 239    EP-A1- 2 858 239
US-A- 6 057 726    US-A1- 2012 025 914
US-A1- 2012 025 914    US-A1- 2016 380 600
US-A1- 2016 380 600

**Beschreibung**

Die vorliegende Erfindung betrifft eine Vorrichtung zur Ansteuerung eines selbstleitenden n-Kanal Endstufenfeldeffekttransistors sowie eine Vorrichtung zur elektronischen Verstärkung einer Wechselspannung in Gegentaktschaltung.

Selbstleitende n-Kanal Endstufenfeldeffekttransistoren, im Folgenden kurz: Endstufentransistor, finden als Leistungstransistoren beispielsweise Anwendung in spannungsgeschalteten Klasse-S Mikrowellen-Leistungsverstärkern und werden über Treiber angesteuert.

Ein Treiber kann als eine Vorrichtung ausgebildet sein, die einen Steuersignaleingang, einen Steuersignalausgang zur Verbindung mit einer Gate-Elektrode des Endstufenfeldeffekttransistors, eine negative Spannungsquelle und eine positive Spannungsquelle umfasst. Eine Source-Elektrode eines Transistors ist mit dem ersten Knotenpunkt, eine Gate-Elektrode des Treibertransistors ist mit dem zweiten Knotenpunkt elektrisch angeschlossen, im Folgenden kurz: angeschlossen, und eine Drain-Elektrode des Treibertransistors ist mit der positiven Spannungsquelle angeschlossen. Ein Widerstand ist mit einem Ende an den zweiten Knotenpunkt angeschlossen. Das andere Ende des Widerstands ist an die positive Spannungsquelle angeschlossen.

Bei Verwendung des Treibertransistors in einem Treiber, der einen als High-Side-Endstufentransistor ansteuert, kann eine Spannung an der Source-Elektrode des Treibertransistors mit einer Ausgangsspannung mitschwingen.

Um den Treibertransistor dann mittels einer negativen Spannung an der Gate-Elektrode des Endstufentransistors zuverlässig sperren zu können, muss die Spannung zwischen der Gate- und Source-Elektrode des Treibertransistors ausreichend negativ sein. In diesem Zustand liegt über dem Widerstand eine hohe Spannung an, und dies führt zu einem Leistungsverlust im Treiber. Daher ist US 4,238,737 mit der Ausbalancierung von Push-Pull-Verstärkern befasst.

US 2012/025914 A1, US 2016/380600 A1 und EP 2 858 239 offenbaren weitere konventionelle Leistungsverstärker.

**Erfindung**

Erfindungsgemäß wird eine Vorrichtung zur Ansteuerung eines selbstleitenden n-Kanal Endstufenfeldeffekttransistors vorgestellt und weiterhin eine Vorrichtung zur elektronischen Verstärkung einer Wechselspannung in Gegentaktschaltung mit den Merkmalen des unabhängigen Anspruchs 1 vorgestellt.

Die Vorrichtung umfasst einen Steuersignaleingang, einen Steuersignalausgang zur Verbindung mit einer Gate-Elektrode des Endstufenfeldeffekttransistors, einen ersten Knotenpunkt, der an den Steuersignalausgang angeschlossen ist, einen zweiten Knotenpunkt, und einen ersten Treibertransistor. Eine Source-Elektrode des ersten Treibertransistors ist an den ersten Knotenpunkt, eine Gate-Elektrode des ersten Treibertransistors ist an den zweiten Knotenpunkt angeschlossen und eine Drain-Elektrode des ersten Treibertransistors ist mit einer Versorgungsspannung angeschlossen oder verbindbar. Ein Widerstand ist mit einem Ende an den zweiten Knotenpunkt angeschlossen. Die Vorrichtung ist dadurch gekennzeichnet, dass der Widerstand mit dem anderen Ende an den ersten Knotenpunkt angeschlossen ist.

Mithilfe des ersten Treibertransistors lässt sich so bewirken, dass am Steuersignalausgang die Versorgungsspannung anliegt wenn am Steuersignaleingang ein Low-Level Signal anliegt.

Durch Anlegen einer negativen Spannung an den zweiten Knotenpunkt gegenüber dem ersten Knotenpunkt wird der erste Treibertransistor gesperrt. Da der Widerstand mit dem anderen Ende an den ersten Knotenpunkt angeschlossen ist, ist der Spannungsabfall über dem Widerstand und damit die Verlustleistung des Treibers, durch die Spannung am Steuersignalausgang bestimmt. Diese ist, zumindest wenn der erste Treibertransistor sperrt, geringer als die Spannung der positiven Spannungsquelle, so dass der Treiber im Schnitt eine geringere Verlustleistung hat.

Die Vorrichtung umfasst eine erste negative Spannungs-quelle, die eine erste Spannung zur Verfügung stellt, und einen zweiten Treibertransistor. Eine Source-Elektrode des zweiten Treibertransistors ist an die erste negative Spannungsquelle angeschlossen, eine Gate-Elektrode des zweiten Treibertransistors ist an den Signaleingang angeschlossen und eine Drain-Elektrode des zweiten Treiber-transistors ist an den ersten Knotenpunkt angeschlossen.

Die Spannung der negativen Spannungsquelle bestimmt dann die Spannung am Steuersignalausgang, wenn der erste Treibertransistor sperrt und der zweite Treibertransistor leitet.

Die Vorrichtung umfasst auch eine zweite negative Spannungsquelle und einen dritten Treibertransistor. Dabei kann eine Source-Elektrode des dritten Treibertransistors mit der zweiten negativen Spannungsquelle, die eine zweite Spannung bereitstellt, angeschlossen sein. Eine Drain-Elektrode des dritten Transistors ist an den zweiten Knotenpunkt angeschlossen.

Mithilfe des dritten Treibertransistors lässt sich bewirken, dass der erste Treibertransistor zuverlässig sperrt, wenn am Signaleingang ein High-Level Signal anliegt. Mithilfe des Widerstandes lässt sich bewirken, dass der erste Treibertransistor leitet, wenn am Signaleingang ein Low-Level Signal anliegt. Insbesondere können ein Widerstandswert des Widerstandes und eine Spannungsdifferenz zwischen der ersten negativen Spannung und der zweiten negativen Spannung so gewählt werden, dass ein Spannungsabfall über den Widerstand bewirkt, dass der erste Transistor zuverlässig sperrt und eine Verlustleistung am Widerstand möglichst gering ist.

Die Vorrichtung umfasst eine Gleichspannungsquelle. Eine Gate-Elektrode des dritten Treibertransistors ist mit einer negativen Seite der Gleichspannungsquelle verbunden und eine positive Seite der Gleichspannungsquelle ist an den Steuersignaleingang angeschlossen.

So lässt sich mithilfe einer Gleichspannungsbeaufschlagung auf das Gate des dritten Treibertransistors bewirken, dass der dritte Treibertransistor zuverlässig die zweite negative Spannung auf den zweiten Knoten schaltet, wenn am Signaleingang das High-Level Signal anliegt.

Der erste Treibertransistor kann ein selbstleitender Feldeffekttransistor sein.

Die weiterhin vorgestellte Vorrichtung umfasst mindestens einen selbstleitenden n-Kanal Endstufenfeldeffekttransistor mit einer Source-Elektrode, deren Potenzial mit einer Ausgangsspannung der Vorrichtung mitschwingt, und einer Vorrichtung zur Ansteuerung des selbstleitenden n-Kanal Endstufenfeldeffekttransistors nach einem der vorangehenden Ansprüche.

Die weiterhin vorgestellte Vorrichtung kann eine fünfte Spannungsquelle umfassen, die eine positive Versorgungsspannung bereitstellt, wobei eine Drain-Elektrode des selbstleitenden n-Kanal Endstufentransistors an die fünfte Spannungsquelle angeschlossen sein kann und die Versorgungsspannung um mindestens eine Größenordnung größer als eine Spannungsdifferenz zwischen der ersten negativen Spannung und der zweiten negativen Spannung sein kann.

Ein integrierter Schaltkreis kann die weiterhin vorgestellte Vorrichtung umfassen.

Die weiterhin vorgestellte Vorrichtung und/oder der integrierte Schaltkreis kann in einem spannungsgeschalteten Klasse-S Mikrowellen-Leistungsverstärker verwendet werden.

Vorteilhafte Weiterbildungen der Erfindung sind in den Unteransprüchen angegeben und in der Beschreibung beschrieben.

**Zeichnungen**

Ausführungsbeispiele der Erfindung werden anhand der Zeichnungen und der nachfolgenden Beschreibung näher erläutert. Es zeigen:

Figur 1    zeigt eine Vorrichtung zur Ansteuerung eines Low-Side Treibertransistors nach Stand der Technik, und

Figur 2    zeigt ein Ausführungsbeispiel der vorliegenden Erfindung zur Ansteuerung eines High-Side Treibertransistors.

**Ausführungsbeispiel**

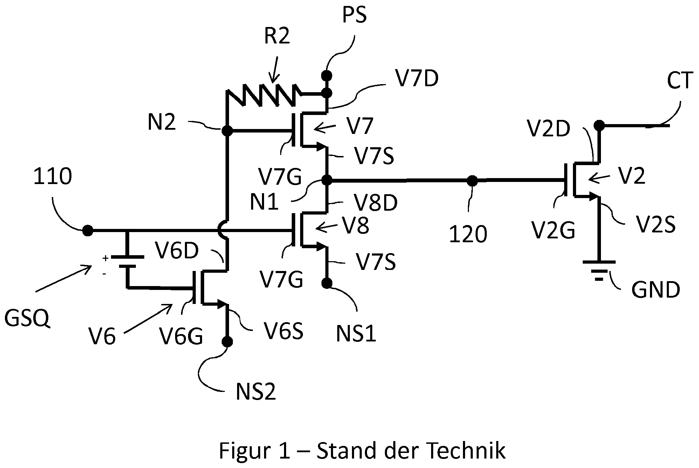

Figur 1 zeigt eine Vorrichtung zur Ansteuerung eines selbstleitenden n-Kanal Low-Side Endstufenfeldeffekttransistors V2 nach Stand der Technik.

Die Vorrichtung umfasst einen ersten Treibertransistor V7, einen Steuersignaleingang 110 und einen Steuersignalausgang 120. Der Steuersignalausgang 120 ist an eine Gate-Elektrode des selbstleitenden n-Kanal Endstufenfeldeffekttransistors V2 angeschlossen oder vorgerichtet, an eine solche Gate-Elektrode angeschlossen zu werden. Die Drain-Elektrode des selbstleitenden n-Kanal Low-Side Endstufenfeldeffekttransistors V2 ist an den Ausgang CT angeschlossen und die Source-Elektrode des selbstleitenden n-Kanal Low-Side Endstufenfeldeffekttransistors V2 ist mit Masse GND verbunden.

Der Steuersignalausgang 120 ist an einen ersten Knotenpunkt N1 angeschlossen. Der erste Knotenpunkt N1 ist an eine Source-Elektrode V7S des ersten Treibertransistors V7 angeschlossen. Eine Drain-Elektrode V7D des ersten Treibertransistors V7 ist an eine positive Spannungsquelle PS angeschlossen. Eine Gate-Elektrode V7G des ersten Treibertransistors V7 ist mit einem zweiten Knotenpunkt N2 angeschlossen. Der Steuersignaleingang 110 ist an eine Gate-Elektrode V8G eines zweiten Treibertransistors V8 angeschlossen. Eine Drain-Elektrode V8D des zweiten Treibertransistors V8 ist an den ersten Knotenpunkt N1 angeschlossen. Der Steuersignaleingang 110 ist weiterhin an eine positive Seite einer Gleichspannungsquelle GSQ angeschlossen. Eine negative Seite der Gleichspannungsquelle GSQ ist an eine Gate-Elektrode V6G eines dritten Treibertransistors V6 angeschlossen. Eine Drain-Elektrode V6D des dritten Treibertransistors V6 ist an den zweiten Knotenpunkt N2 angeschlossen.

Eine Source-Elektrode V8S des zweiten Treibertransistors V8 ist an eine erste negative Spannungsquelle NS1, die eine erste negative Spannung -Ve bereitstellt, angeschlossen. Eine Source-Elektrode V6S des dritten Treibertransistors V6 ist an eine zweite negative Spannungsquelle NS2, die eine zweite negative Spannung -Vee bereitstellt, die geringer als die erste negative Spannung -Ve ist, angeschlossen.

Zwischen der positiven Spannungsquelle PS und dem zweiten Knotenpunkt N2 ist ein Widerstand R2 angeordnet, der an die positive Spannungsquelle PS und den zweiten Knotenpunkt N2 angeschlossen ist.

Die zum Sperren von V7 und damit V2 benötigte Verlustleistung ist dabei durch die Stromstärke des Stroms bestimmt, der durch den Widerstand R2 fließt, der wiederum von abhängt:

$$P_{Ver} = (V_{PS} - Vee)^2/R2$$

Da die Spannungsdifferenz $V_{PS}$ - Vee bei Leistungsverstärkern um mindestens eine Größenordnung kleiner ist, als die Versorgungsspannung des Leistungsverstärkers +Vdd, ist die Verlustleistung des Widerstandes $P_{Ver}$ relativ gering.

Bei Verwendung als High-Side Treiber ist das Drain von V2 an die Versorgungsspannung des Leistungsverstärkers +Vdd angeschlossen, während Source von V2 an CT angeschlossen ist. Für eine korrekte Funktion des Treibers muss $V_{PS}$ mindestens so hoch wie die Versorgungsspannung des Leistungsverstärkers +Vdd sein. Dadurch wird die Verlustleistung von R2 erheblich größer.

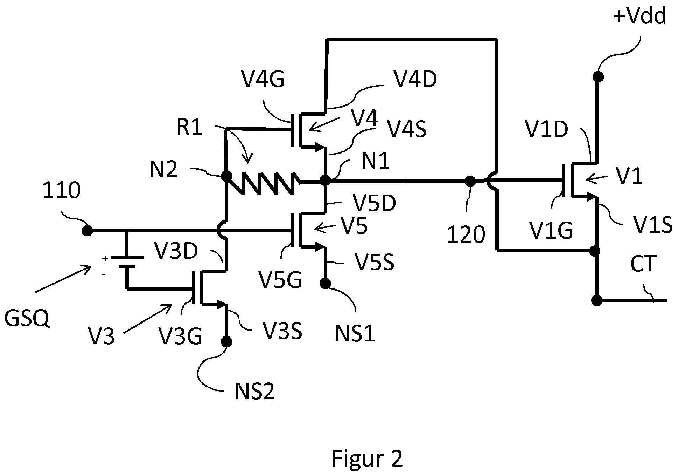

Figur 2 zeigt eine Vorrichtung 100 zur Ansteuerung eines selbstleitenden n-Kanal High-Side Endstufenfeldeffekttransistors V1 gemäß einem Ausführungsbeispiel der Erfindung, die unter anderem weniger Verlustleistung hat.

Im Unterschied zu der Vorrichtung aus Figur 1 ist hier die Source-Elektrode des selbstleitenden n-Kanal High-Side Endstufenfeldeffekttransistors V1 an den Ausgang CT angeschlossen die Drain-Elektrode des selbstleitenden n-Kanal High-Side Endstufenfeldeffekttransistors V1 an eine positive Spannungsquelle +Vdd angeschlossen. Weiterhin ist der Widerstand R1 zwischen dem ersten und dem zweiten Knotenpunkt N1, N2 angeordnet.

Die in Figur 2 gezeigte Vorrichtung 100 umfasst einen ersten Treibertransistor V4, einen Steuersignaleingang 110 und einen Steuersignalausgang 120. Der Steuersignalausgang 120 ist an eine Gate-Elektrode V1G des selbstleitenden n-Kanal Endstufenfeldeffekttransistors V1 angeschlossen oder vorgerichtet, an eine solche Gate-Elektrode V1G angeschlossen zu werden.

Der Steuersignalausgang 120 ist mit einem ersten Knotenpunkt N1 angeschlossen. Der erste Knotenpunkt N1 ist an eine Source-Elektrode V4S des ersten Treibertransistors V4 angeschlossen. Eine Gate-Elektrode V4G des ersten Treibertransistors V4 ist mit einem zweiten Knotenpunkt N2 angeschlossen. Der Steuersignaleingang 110 ist an eine Gate-Elektrode V5G eines zweiten Treibertransistors V5 angeschlossen. Eine Drain-Elektrode V5D des zweiten Treibertransistors V5 ist an den ersten Knotenpunkt N1 angeschlossen. Der Steuersignaleingang 110 ist weiterhin an eine positive Seite einer Gleichspannungsquelle GSQ angeschlossen. Eine negative Seite der Gleichspannungsquelle GSQ ist an eine Gate-Elektrode V3G eines dritten Treibertransistors V3 angeschlossen. Eine Drain-Elektrode V3D des dritten Treibertransistors V3 ist an den zweiten Knotenpunkt N2 angeschlossen.

Eine Source-Elektrode V5S des zweiten Treibertransistors V5 ist an eine erste negative Spannungsquelle NS1, die eine erste negative Spannung bereitstellt, angeschlossen. Eine Source-Elektrode V3S des dritten Treibertransistors V3 ist an eine zweite negativen Spannungsquelle NS2, die eine zweite negative Spannung bereitstellt, die geringer als die erste negative Spannung ist, angeschlossen.

Zwischen dem ersten und dem zweiten Knotenpunkt N1, N2 ist ein Widerstand R1 angeordnet, der an die Knotenpunkte N1, N2 angeschlossen ist.

Eine Drain-Elektrode V4D des ersten Treibertransistors V4 ist an eine positive Spannungsquelle, oder an eine Source-Elektrode V1S des selbstleitenden n-Kanal Endstufenfeldeffekttransistors V1 angeschlossen oder hierfür verbindbar vorgerichtet.

In einer vorteilhaften beispielhaften Ausführungsform der Erfindung ist der erste Transistor V4 ein selbstleitender Feldeffekttransistor.

Ein weiteres Ausführungsbeispiel der Erfindung stellt eine Vorrichtung zur elektronischen Verstärkung einer Wechselspannung in Gegentaktschaltung dar. Die Vorrichtung umfasst mindestens einen selbstleitenden n-Kanal Endstufenfeldeffekttransistor V1 an einer Source-Elektrode V1S deren Potenzial an eine Ausgangsspannung der Vorrichtung mitschwingt. Zur Ansteuerung des selbstleitenden n-Kanal Endstufenfeldeffekttransistors V1 umfasst die Vorrichtung die in Figur 2 gezeigte Vorrichtung zur Ansteuerung des selbstleitenden n-Kanal High-Side Endstufenfeldeffekttransistors V1.

Die Versorgungsspannung +Vdd, mit der der Endstufenfeldeffekttransistor V1 versorgt wird, ist dabei beispielsweise um mindestens eine Größenordnung größer als eine Spannungsdifferenz zwischen der ersten negativen Spannung und der zweiten negativen Spannung.

Die Drain-Elektrode des ersten Treibertransistors V4 kann an die Drain-Elektrode des selbstleitenden n-Kanal Endstufenfeldeffekttransistors oder an dessen Source-Elektrode angeschlossen sein.

In weiteren Ausführungsbeispielen der Erfindung sind die Vorrichtung zur elektronischen Verstärkung und/oder die Vorrichtung zur Ansteuerung eines selbstleitenden n-Kanal High-Side Endstufenfeldeffekttransistors als integrierter Schaltkreis realisiert.

Schließlich werden in einem Anwendungsbeispiel der vorliegenden Erfindung die Vorrichtung zur elektronischen Verstärkung und/oder die Vorrichtung zur Ansteuerung eines selbstleitenden n-Kanal High-Side Endstufenfeldeffekttransistors in einem spannungsgeschalteten Klasse-S Mikrowellen-Leistungsverstärker verwendet.

In einem Ausführungsbeispiel betrifft die Erfindung eine Vorrichtung zum verlustarmen Ansteuern von Leistungs-Transistoren in elektronischen Wechselspannungs-Verstärkerstufen in Gegentaktschaltung, wobei diese Verstärker mindestens einen selbstleitenden n-Kanal FET als Treibertransistor aufweisen, dessen Source nicht auf konstantem Potenzial liegt, sondern mit der Ausgangsspannung des Verstärkers mitschwingt, was auch als floatendes Potenzial bezeichnet wird.

Vorzugsweise kann die erfindungsgemäße Vorrichtung als "High-side-driver" in spannungsgeschalteten Klasse-S Mikrowellen-Leistungsverstärkern eingesetzt werden.

Die Funktion der erfindungsgemäßen Vorrichtung bei Verwendung als "High-side-driver" für einen spannungsgeschalteten Klasse-S Mikrowellen-Leistungsverstärker wird im Folgenden anhand der Figur 2 beschrieben.

Der Endstufen-FET V1 wird vom High-side-driver angesteuert, bestehend aus V3, V4, V5 und R1. An der Source-Elektrode des Treibertransistors (im Folgenden kurz: Transistor) V1 wird die Ausgangsspannung abgegriffen. Am Steuersignalausgang 120 liegt die Steuerspannung des High-side-drivers an, die an die Gate-Elektrode V5G angelegt wird. Die Steuerspannung wird zudem mit einem DC Bias beaufschlagt und mit dem Aufschlag an die Gate-Elektrode V3G des Transistors V3 angelegt.

Die im Folgenden genannten Spannungen beziehen sich - soweit nicht anders beschrieben - auf Masse oder das Potenzial der Source-Elektrode V2S

Fall I: V1 soll leitend sein

Ein niedriger Pegel wird an den Steuersignaleingang angelegt. Dies bewirkt, dass die Transistoren V3 und V5 sperren. Daher kann kein Strom durch den Widerstand R1 fließen, der notwendig wäre, den selbstleitenden Transistor V4 des Ausführungsbeispiels zu sperren. Transistor V4 ist also leitend.

Da der Kanal von V4 (Drain-Source-Spannung) parallel zum Eingang (Gate-Source-Spannung) von V1 liegt, bewirkt Transistor V4, wenn er leitend ist, dass die Spannungs-differenz zwischen Gate- und Source-Elektrode des selbstleitenden Transistors V1 Null ist. Transistor V1 ist dann auch leitend.

Fall II: V1 soll sperren

Ein hoher Pegel wird an den Steuersignaleingang 110 angelegt. Dies bewirkt, dass die Transistoren V3 und V5 leiten. Am Knotenpunkt N1 liegt dann die Spannung -Ve an. Diese Spannung -Ve wird auch an die Gate-Elektrode des Transistors V1 angelegt. Am Knotenpunkt N2 liegt die Spannung -Vee an, die niedriger als -Ve ist. Zwischen den Knotenpunkten N1 und N2 besteht also eine Spannungsdifferenz. Daher fließt Strom durch den Widerstand R1, der notwendig ist, den selbstleitenden Transistor V4 des Ausführungsbeispiels zu sperren. Transistor V4 sperrt also. Die Spannung an der Source-Elektrode V1S ist nie negativ, während an der Gate-Elektrode V1G die negative Spannung -Ve anliegt, so dass zwischen Source- und Gate-Elektrode ein Spannungsabfall vorliegt. Dieser bewirkt, dass V1 sperrt.

Die zum Sperren benötigte Verlustleistung ist dabei durch die Stromstärke des Stroms bestimmt, der durch den Widerstand R1 fließt:

$$P_{Ver} = (-Ve - Vee)^2/R1$$

Insbesondere ist die Verlustleistung unabhängig von einer Versorgungspannung, mit der der selbstleitende n-Kanal Endstufenfeldeffekttransistor V1 versorgt wird.

In weiteren beispielhaften Ausgestaltungen der Erfindung ist der Treiber DC-gekoppelt und enthält keine reaktiven Elemente. Dann arbeitet der Treiber unabhängig von Trägerfrequenz und Tastverhältnis.

In einer noch weiteren beispielhaften Ausgestaltung ist die Erfindung als integrierter Schaltkreis realisiert.

**Patentansprüche**

1.  Vorrichtung zur elektronischen Verstärkung einer Wechselspannung in Gegentaktschaltung, umfassend:
    mindestens einen selbstleitenden n-Kanal Endstufenfeldeffekttransistor (V1) mit einer Source-Elektrode (V1S), deren Potenzial mit einer Ausgangsspannung der Vorrichtung mitschwingt, einer Drain-Elektrode (V1D) die an eine positive Versorgungsspannung (+Vdd) angeschlossen ist, und eine Vorrichtung (100) zur Ansteuerung des selbstleitenden n-Kanal Endstufenfeldeffekttransistors (V1) umfassend:

    einen Steuersignaleingang (110),
    einen Steuersignalausgang (120) zur Verbindung mit einer Gate-Elektrode (V1G) des Endstufenfeldeffekttransistors (V1),
    einen ersten Knotenpunkt (N1), der an den Steuersignalausgang (120) angeschlossen ist, einen zweiten Knotenpunkt (N2),
    einen ersten Transistor (V4),
    wobei eine Source-Elektrode (V4S) des ersten Transistors (V4) an den ersten Knotenpunkt (N1) angeschlossen, eine Gate-Elektrode (V4G) des ersten Transistors (V4) an den zweiten Knotenpunkt (N2) angeschlossen und eine Drain-Elektrode (V4D) des ersten Transistors (V4) an die Drain-Elektrode des selbstleitenden n-Kanal Endstufenfeldeffekttransistors oder an dessen Source-Elektrode angeschlossen ist, und einem Widerstand (R1), der mit einem Ende an den zweiten Knotenpunkt (N2) angeschlossen ist, wobei der Widerstand (R1) mit dem anderen Ende an den ersten Knotenpunkt (N1) angeschlossen ist, weiterhin umfassend:

    eine erste negative Spannungsquelle (NS1), die eine erste Spannung zur Verfügung stellt, einen zweiten Transistor (V5), wobei eine Source-Elektrode (V5S) des zweiten Transistors (V5) mit der ersten negativen Spannungsquelle (NS1) angeschlossen, eine Gate-Elektrode (V5G) des zweiten Transistors (V5) an den Steuersignaleingang (110) angeschlossen und eine Drain-Elektrode (V5D) des zweiten Transistors (V5) an den ersten Knotenpunkt (N1) angeschlossen ist, wobei eine zweite negative Spannungsquelle (NS2) eine vom Betrag her größere Spannung als die erste negative Spannungsquelle (NS1) bereitstellt, weiterhin umfassend:

einen dritten Transistor (V3), wobei eine Source-Elektrode (V3S) des dritten Transistors (V3) mit der zweiten negativen Spannungsquelle verbunden und eine Drain-Elektrode (V3D) des dritten Transistors (V3) an den zweiten Knotenpunkt (N2) angeschlossen ist, die Vorrichtung weiterhin umfassend: eine Gleichspannungsquelle (GSQ), wobei eine positive Seite der Gleichspannungsquelle (GSQ) an den Steuersignaleingang (110) angeschlossen und eine negative Seite der Gleichspannungsquelle (GSQ) an eine Gate-Elektrode (V3G) des dritten Transistors (V3) angeschlossen ist.

2. Vorrichtung nach dem Anspruch 1 wobei der erste Transistor (V4) ein selbstleitender Feldeffekttransistor ist.

3. Vorrichtung nach einem der vorangehenden Ansprüche, wobei die positive Versorgungsspannung um mindestens eine Größenordnung größer als eine Spannungs-differenz zwischen der ersten Spannung und der zweiten Spannung ist.

4. Integrierter Schaltkreis, wobei der Schaltkreis eine Vorrichtung nach einem der vorangehenden Ansprüche umfasst.

5. Verwendung der Vorrichtung nach einem der vorangehenden Ansprüche in einem spannungsgeschalteten Klasse-S Mikrowellen-Leistungsverstärker.

**Claims**

1. A device for electronically amplifying an alternating voltage in push-pull circuit comprising:

at least one self-conducting n-channel output stage field effect transistor (V1) with a source electrode (V1S), the potential of which oscillates with an output voltage of the device, a drain electrode (V1D) which is connected to a positive supply voltage (+Vdd), and a device (100) for controlling the self-conducting n-channel output stage field effect transistor (V1), comprising:

a control signal input (110), a control signal output (120) for connection to a gate electrode (V1G) of the output stage field effect transistor (V1), a first node (N1) which is connected to the control signal output (120), a second node (N2), a first transistor (V4), wherein a source electrode (V4S) of the first transistor (V4) is connected to the first node (N1), a gate electrode (V4G) of the first transistor (V4) is connected to the second node (N2), and a drain electrode (V4D) of the first transistor (V4) is connected to the drain electrode of the self-conducting n-channel output stage field effect transistor or to the source electrode thereof, and a resistor (R1) which is connected with one end to the second node (N2), wherein the resistor (R1) is connected with the other end to the first node (N1), further comprising:

a first negative voltage source (NS1) which supplies a first voltage, a second transistor (V5), wherein a source electrode (V5S) of the second transistor (V5) is connected to the first negative voltage source (NS1), a gate electrode (V5G) of the second transistor (V5) is connected to the control signal input (110), and a drain electrode (V5D) of the second transistor (V5) is connected to the first node (N1), wherein a second negative voltage source (NS2) provides a voltage that is greater than the first negative voltage source (NS1), further comprising:

a third transistor (V3), wherein a source electrode (V3S) of the third transistor (V3) is connected to the second negative voltage source and a drain electrode (V3D) of the third transistor (V3) is connected to the second node (N2), the device further comprising: a DC voltage source (GSQ), wherein a positive side of the DC voltage source (GSQ) is connected to the control signal input (110) and a negative side of the DC voltage source (GSQ) is connected to a gate electrode (V3G) of the third transistor (V3).

2. The device according to Claim 1, wherein the first transistor (V4) is a self-conducting field effect transistor.

**3.** The device according to any one of the preceding claims, wherein the positive supply voltage is at least one order of magnitude greater than a voltage difference between the first voltage and the second voltage.

**4.** An integrated circuit, wherein the circuit comprises a device according to any one of the preceding claims.

**5.** Use of the device according to any one of the preceding claims in a voltage-switched class S microwave power amplifier.

**Revendications**

**1.** Dispositif destiné à amplifier électroniquement une tension alternative dans un circuit push-pull, comprenant :

au moins un transistor à effet de champ d'étage final à canal n autoconducteur (V1) avec une électrode de source (V1S), dont le potentiel oscille avec une tension de sortie du dispositif, d'une électrode de drain électrode de drain (V1D) qui est connectée à une tension d'alimentation positive (+Vdd),
et un dispositif (100) pour la commande du transistor à effet de champ d'étage final à canal n autoconducteur (V1) comprenant :

une entrée de signal de commande (110),
une sortie de signal de commande (120) pour la liaison avec une électrode de grille (V1G) du transistor à effet de champ d'étage final (V1),
un premier nœud (N1), qui est connecté à la sortie de signal de commande (120),
un deuxième nœud (N2),
un premier transistor (V4),
dans lequel une électrode de source (V4S) du premier transistor (V4) est connectée au premier nœud (N1), une électrode de grille (V4G) du premier transistor (V4) est connectée au deuxième nœud (N2) et une électrode de drain (V4D) du premier transistor (V4) est connectée à l'électrode de drain du transistor à effet de champ d'étage final à canal n autoconducteur ou à son électrode de source, et
une résistance (R1), qui est connectée par une extrémité au deuxième nœud (N2), la résistance (R1) étant connectée par l'autre extrémité au premier nœud (N1), comprenant en outre :

une première source de tension négative (NS1) qui met à disposition une première tension, un deuxième transistor (V5),
dans lequel une électrode de source (V5S) du deuxième transistor (V5) est connectée par la première source de tension négative (NS1), une électrode de grille (V5G) du deuxième transistor (V5) est connectée à l'entrée de signal de commande (110) et une électrode de drain (V5D) du deuxième transistor (V5) est connectée au premier nœud (N1), une deuxième source de tension négative (NS2) fournissant une tension d'une amplitude supérieure à la première source de tension négative (NS1),
comprenant en outre :

un troisième transistor (V3),
dans lequel une électrode de source (V3S) du troisième transistor (V3) est reliée à la deuxième source de tension négative et une électrode de drain (V3D) du troisième transistor (V3) est connectée au deuxième nœud (N2),
le dispositif comprenant en outre :
une source de tension continue (GSQ), dans laquelle un côté positif de la source de tension continue (GSQ) est connecté à l'entrée de signal de commande (110) et un côté négatif de la source de tension continue (GSQ) est connecté à une électrode de grille (V3G) du troisième transistor (V3).

**2.** Dispositif selon la revendication 1, dans lequel le premier transistor (V4) est un transistor à effet de champ autoconducteur.

**3.** Dispositif selon une des revendications précédentes, dans lequel la tension d'alimentation positive est supérieure d'au moins un ordre de grandeur à une différence de tension entre la première tension et la seconde tension.

**4.** Circuit intégré, dans lequel le circuit comprend un dispositif selon une des revendications précédentes.

**5.** Utilisation du dispositif selon une des revendications précédentes dans un amplificateur de puissance microondes de classe S à tension connectée.

Figur 1 – Stand der Technik

EP 3 602 777 B1

Figur 2

EP 3 602 777 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4238737 A
- US 2012025914 A1
- US 2016380600 A1
- EP 2858239 A